# EUROPÄISCHE PATENTSCHRIFT

(11) **EP 1 387 609 B1**
(45) Veröffentlichungstag und Bekanntmachung des Hinweises auf die Patenterteilung: **12.11.2008**
(21) Anmeldenummer: 03017143.3
(22) Anmeldetag: 29.07.2003
(51) Int. Cl.: H05K 7/20, B60H 1/00

(54) **Elektronische Einrichtung, insbesondere elektronische Regler für eine elektromechanische Anordnung wie beispielsweise ein Fahrzeuggebläse**
Electronic arrangement, particularly for electronic controller of electomechanical device, e.g. fan into vehicle
Arrangement électronique pour un régulateur d' un dispositif électromécanique comme par exemple un ventilateur dans une automobile

(30) Priorität: 30.07.2002 DE 10234586
(43) Veröffentlichungstag der Anmeldung: 04.02.2004
(73) Patentinhaber: Behr-Hella Thermocontrol GmbH, D-70469 Stuttgart (DE)
(72) Erfinder: Röhling, Hans-Dieter, 59558 Lippstadt (DE); Metzner, Ralf, 59597 Erwitte (DE)
(74) Vertreter: Hilleringmann, Jochen

(56) Entgegenhaltungen:
- EP-A- 0 652 694
- EP-A- 1 082 993
- FR-A- 2 805 961
- US-A1- 2002 041 506

## Beschreibung

Die Erfindung betrifft eine elektronische Einrichtung für insbesondere eine elektromechanische Anordnung und insbesondere einen elektronischen Regler für ein Fahrzeuggebläse.

Leistungsregler oder andere elektronische (Leistungs-)Bauteile bedürfen der Kühlung, um vor thermischen Schäden geschützt zu sein. Zum Zwecke der Kühlung werden derartige elektronische Bauteile wie insbesondere Transistoren thermisch mit Kühlkörpern gekoppelt, die eine Wärmesenke bilden. Das zu kühlende elektronische Bauteil weist zu diesem Zweck ein Wärmeabführelement auf, das in thermischem Kontakt mit dem eigentlichen Halbleiterbauelement steht und an einer Seite des Gehäuses des Bauteils freiliegt. Dieses zu kühlende Wärmeabführelement kann auch zusätzlich als elektrisches Anschlusskontaktelement genutzt werden. Ferner ragen aus dem Gehäuse weitere Anschlusskontaktelemente heraus oder sind in der Außenseite des Gehäuses angeordnet. Das Wärmeabführelement ist mit dem Kühlkörper thermische verbunden, was zumeist mechanisch erfolgt, indem das Wärmeabführelement z.B. mittels einer Schraube an dem Kühlkörper festgeschraubt ist. Zwischen dem Wärmeabführelement und dem Kühlkörper kann noch eine Wärmeleitpaste o.dgl. Unebenheiten ausfüllendes thermisch leitendes Material angeordnet sein.

Für den Betrieb eines zu kühlenden elektronischen Bauteils spielt der Wärmetransport zum Kühlkörper hin eine entscheidende Rolle. Der Wärmetransport auf Grund lediglich einer mechanischen Berührung von Wärmeabführelement und Kühlkörper ist nicht optimal. Wesentlich günstiger wäre es, wenn das Wärmeabführelement stoffschlüssig, beispielsweise durch Verlötung mit dem Kühlkörper verbunden ist. Dies allerdings setzt voraus, dass das Material des Kühlkörpers verlötbar ist. Zu diesem Zweck müsste der Kühlkörper beispielsweise aus Kupfer bestehen und nicht, wie bisher üblich, aus Aluminium oder einer Aluminiumlegierung. Die letztgenannten Materialien haben gegenüber Kupfer den Vorteil der geringeren spezifischen Wichte und der besseren thermischen Leitfähigkeit.

Es ist aus US-A-2002/0041506 bekannt, einen Transistor zwecks thermischer Kopplung mit einer Kupferplatte zu verlöten und diese Kupferplatte über eine thermisch leitende Zwischenschicht in Kontakt mit einem Kühlkörper zu bringen.

Der Erfindung liegt die Aufgabe zu Grunde, eine elektronische Einrichtung, insbesondere einen elektronischen Regler für eine elektromechanische Anordnung wie beispielsweise ein Fahrzeuggebläse zu schaffen, wobei als Kühlkörper für das zu kühlende elektronische Bauteil weiterhin ein leichtgewichtiges Material eingesetzt wird, der thermische Kontakt zwischen Bauteil und Kühlkörper aber verbessert ist.

Zur Lösung dieser Aufgabe wird mit der Erfindung eine elektronische Einrichtung, insbesondere ein elektronischer Regler für eine elektromechanische Anordnung wie beispielsweise ein Fahrzeuggebläse vorgeschlagen, wobei die Einrichtung versehen ist mit den Merkmalen des Anspruchs 1; Weiterbildungen der Erfindung sind Gegenstand der Unteransprüche.

Nach der Erfindung ist also vorgesehen, das zu kühlende Wärmeabführelement des elektronischen Bauteils stoffschlüssig mit einer Kupferschicht zu verbinden, die ihrerseits in thermischem Kontakt mit dem Kühlkörper steht. Durch die stoffschlüssige Anbindung des Wärmeabführelements mit der Kupferschicht, was beispielsweise und insbesondere durch eine Verlötung von Wärmeabführelement und Kupferschicht, aber auch durch eine Verklebung beider mittels eines thermisch leitenden Klebers erfolgt, kommt es zunächst einmal zu einer schnellen Verteilung der Wärme von dem Wärmeabführelement über die gesamte Fläche und Ausdehnung der Kupferschicht ("Wärmetransportaufspreizung"). Darüber hinaus erfolgt der Wärmetransport von dem Wärmeabführelement in die Kupferschicht auf Grund der stoffschlüssigen Verbindung beider Elemente extrem rasch. Die Erfindung ist also sowohl hinsichtlich eines verbesserten Wärmeabtransports vom Wärmeabführelement als auch hinsichtlich der Verteilung der abgeführten Wärme über die zweidimensionale Ausbreitung der Kupferschicht von Vorteil. Von der Kupferschicht erfolgt dann der Wärmetransport zum eigentlichen Kühlkörper infolge der thermischen Verbindung beider.

Zur weiteren Verbesserung des Wärmetransports von der Kupferschicht zum Kühlkörper ist erfindungsgemäß vorgesehen, dass das Material der Kupferschicht durch thermisches Spritzen auf den Kühlkörper aufgebracht und infolge dieses Aufbringungsvorgangs mit dem Kühlkörper innig verbunden ist. Durch diesen Thermospritzvorgang kommt es zu einer ebenfalls stoffschlüssigen Verbindung zwischen der Kupferschicht und dem Kühlkörper, womit das gesamte für den Wärmeabtransport erforderliche Wärmetransportsystem aus einzelnen stoffschlüssig und damit bezüglich der Wärmeübergangswiderstände optimalen thermischen Verbindungen besteht.

Es existieren unterschiedliche Verfahren zum thermischen Spritzen von Materialien auf Oberflächen. Vorteilhafterweise wird zur Aufbringung der Kupferschicht auf den Kühlkörper entweder ein Lichtbogenspritz-, oder ein Detonationsspritz-, oder ein Flammspritz-, insbesondere Hochgeschwindigkeits-Flammspritz- oder ein Plasmaspritzverfahren eingesetzt. Von besonderem Vorteil im Zusammenhang mit der Erfindung ist der Einsatz eines so genannten Kaltgasspritzverfahrens, wie es beispielsweise in EP-A-0 911 425, EP-A-1 082 993, DE-A-41 41 020, DE-A-197 47 386 oder DE-A-100 37 212 beschrieben ist. Der Vorteil des Einsatzes des Kaltgasspritzens zum Aufbringen der Kupferschicht auf den Kühlkörper hat im Zusammenhang mit der Erfindung den Vorteil, dass die aufgespritzten Kupferpartikel auf Grund der vergleichsweise niedrigen Temperaturen nicht oxidieren und damit die Wärmeleitfähigkeit des Kupfers nicht leidet. Außerdem ist auf Grund der hohen Geschwindigkeiten, mit der die Kupferpartikel beim Kaltgasspritzen in das Substrat (hier den Kühlkörper) "eingeschossen" werden, eine hohe Materialdichte der Kupferschicht und eine gute Verkrallung der Kupferschicht in das vergleichsweise weiche Material des Kühlkörpers (im Regelfall Aluminium oder eine Aluminiumlegierung) gegeben.

In vorteilhafter Weiterbildung der Erfindung ist ferner vorgesehen, dass die Anschlusskontaktelemente des elektronischen Bauteils elektrisch und mechanisch mit den Anschlusskontaktfeldern einer Leiterplatine verbunden sind, die ihrerseits auf der dem Kühlkörper abgewandten Seite des elektronischen Bauteils angeordnet ist. Somit ist das elektronische Bauteil quasi "über Kopf" auf der Leiterplatine angeordnet; denn bisher werden die Wärmeabführkontakte von zu kühlenden elektronischen Bauelementen dann, wenn eine Metallisierung der Leiterplatine zur Abführung der Wärme eingesetzt wird, mit dem Abführelement auf der Platine aufliegend angeordnet. Die Verbindung des elektronischen Bauteils sowohl mit dem Kühlkörper als auch mit der Leiterplatine durch Verlötung erfolgt bei der zuvor beschriebenen Konstruktion zweckmäßigerweise durch eine Dampfphasenlötung.

Zum Ausgleich von Toleranzen ist es von Vorteil, wenn zwischen dem Gehäuse des elektronischen Bauteils und der Leiterplatine ein elastisches Toleranzausgleichselement in Form eines flexiblen vorgebogenen Elements o.dgl. angeordnet ist.

Die Erfindung wird nachfolgend anhand eines Ausführungsbeispiels unter Bezugnahme auf die Zeichnung näher erläutert. Im einzelnen zeigen dabei:
- Fig. 1: einen Längsschnitt durch einen Kühlkörper mit thermisch mit diesem gekoppelten und elektrisch auf einer Leiterplatine angebundenen zu kühlenden elektrischen Bauteil und
- Fig. 2: eine Ansicht entlang der Linie II-II der Fig. 1.

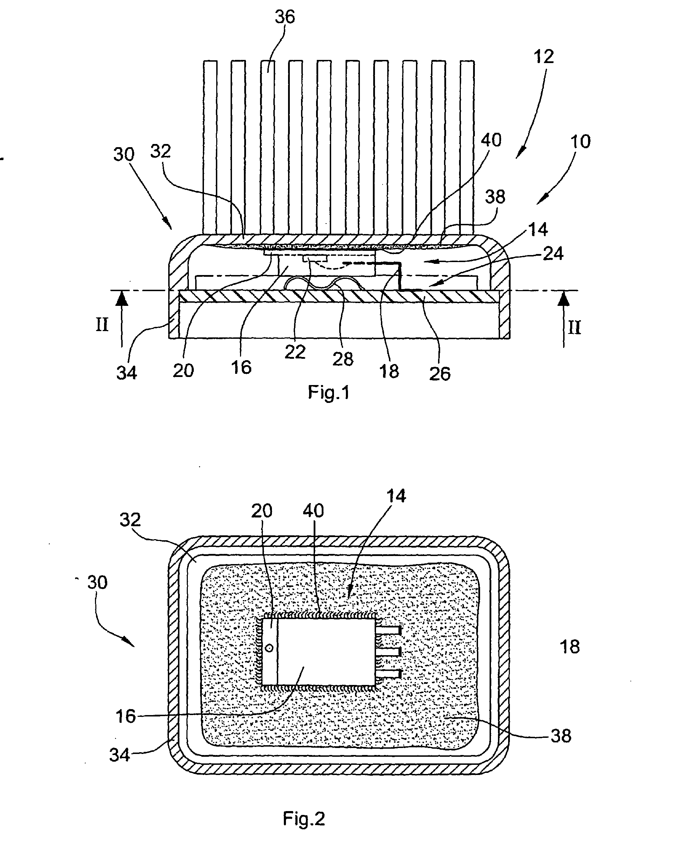

Fig. 1 zeigt im Schnitt einen elektronischen Regler 10 für ein Fahrzeuggebläse mit unter anderem einem Kühlkörper 12, der der von dem Gebläsemotor erzeugten Luftströmung ausgesetzt ist und durch diese gekühlt wird.

Der Regler 10 weist einen Leistungstransistor 14 auf, der mit einem Kunststoffgehäuse 16 versehen ist, aus dem in diesem Fall drei Anschlusskontaktelemente 18 in Form von so genannten "Anschlussbeinchen" herausragen. Auf einer Seite des Gehäuses 16 wird dessen Außenfläche zumindest teilweise von einem Wärmeabführelement 20 aus einem metallischen Material gebildet, auf dem gegebenenfalls elektrisch isoliert das eigentliche Halbleitersubstrat 22 des Leistungstransistors 14 angeordnet ist (siehe Fig. 1). Die Anschlusskontaktelemente 18 sind zu der dem Wärmeabführelement 20 abgewandten Außenseite des Gehäuses 16 des Leistungstransistors 14 hin abgewinkelt und bei 24 elektrisch mit (nicht gezeigten) Lötflächen einer Leiterplatine 26 verbunden. Zwischen dem Gehäuse 16 und der Leiterplatine 26 kann sich zwecks Toleranzausgleichs ein flexibles bzw. auf andere Weise elastisches Toleranzausgleichselement 28 befinden.

Die Leiterplatine 26 ist innerhalb eines napfförmigen Teils 30 des Kühlkörpers 12 angeordnet, wobei dieser napfförmige Teil 30 einen Bodenabschnitt 32 mit umlaufendem hochstehenden Rand 34 aufweist. Von dem Bodenabschnitt 32 stehen eine Vielzahl von Kühlfingern 36 ab. Der napfförmige Teil 30 und die Kühlfinger 36 des Kühlkörpers 12 sind einstückig miteinander ausgebildet.

Die Besonderheit des hier beschriebenen und in der Zeichnung dargestellten elektronischen Reglers 10 besteht in der Art und Weise der thermischen Anbindung des Leistungstransistors 14 an den Kühlkörper 12. Diese thermische Anbindung umfasst eine Kupferschicht 38, die auf den Bodenabschnitt 32 des napfförmigen Teils 30 des Kühlkörpers 12 durch thermisches Spritzen und insbesondere durch Hochgeschwindigkeits-Flamm-(Kaltgas-)Spritzen aufgebracht ist. Durch diese Kupferschicht 38 wird nun der Kühlkörper 12, der aus Aluminium oder einer Aluminiumlegierung besteht, verlötbar. Somit lässt sich nun durch normales Lot 40 eine stoffschlüssige Verbindung des ebenfalls lötbaren Wärmeabführelements 20 mit dem Kühlkörper 12 realisieren.

Die löttechnische Verbindung des Leistungstransistors 14 zum einen zwecks elektrischer Anbindung an die Leiterplatine 26 und zum anderen zwecks thermischer Anbindung an die thermische bespritzte Kupferschicht 38 des Kühlkörpers 12 erfolgt vorteilhafterweise durch eine Dampfphasenlötung, wie sie z.B. in EP-A-1 036 626 beschrieben ist. Um bei diesem Prozess die Anschlusskontaktelemente 18 in einen für die Lötung zuverlässigen Kontakt mit der Leiterplatine 26 zu bringen, ist das Toleranzausgleichselement 28 zwischen dem Gehäuse 16 und der Leiterplatine 26 angeordnet.

Durch den extrem widerstandsarmen weil mittels der Verlötung 40 stoffschlüssigen thermischen Übergang zwischen dem Wärmeabführelement 20 und der Kupferschicht 38 kommt es zu einem extrem guten und damit auch schnellen Wärmetransport von dem Wärmeabführelement 20 in die Kupferschicht 38 hinein. In dieser Kupferschicht 38 verteilt sich nun die Wärme rasch in alle Richtungen, wodurch es zu einer "Aufspreizung" des Wärmetransportstroms innerhalb der Ebene, in der sich die Kupferschicht 38 erstreckt, kommt. Die auf diese Weise "aufgespreizte" Wärme gelangt nun wegen des großflächigen Kontakts der Kupferschicht 38 zum Kühlkörper 12 schnell in diesen hinein, wobei auch dieser Wärmeübergang denkbar widerstandsarm ist, da die Kupferschicht 38 stoffschlüssig mit dem Kühlkörper (hier dem Bodenabschnitt 32 des napfförmigen Teils 30 des Kühlkörpers 12) verbunden ist. Die Kontaktfläche von Kupferschicht 38 und Kühlkörper 12 ist größer als die Flächenausdehnung der Kupferschicht 38, da die Kupferpartikel durch das Kaltgasspritzen bedingt mit hoher Geschwindigkeit in das (weiche) Aluminium-Material des Kühlkörpers 12 vergleichsweise weit in diesen eindringen und es somit zu einem Umschließen der grenzschichtnahen Kupferpartikel durch das Aluminium-Material des Kühlkörpers 12 kommt. Entscheidend für das Ausführungsbeispiel ist also, erkannt zu haben, dass man mit einer thermisch gespritzten Kupferschicht 38 nicht nur einen optimalen Wärmeübergang vom Kupfer zum Kühlkörper 12 sondern auch eine lötfähige Beschichtung des Kühlkörpers 12 geschaffen hat, an den nun das Wärmeabführelement 20 des Transistors 14 sich durch Verlötung thermisch optimal ankoppeln lässt.

### BEZUGSZEICHENLISTE

- 10: Regler
- 12: Kühlkörper
- 14: Leistungstransistor
- 16: Gehäuse
- 18: Anschlusskontaktelement
- 20: Wärmeabführelement
- 22: Halbleitersubstrat
- 26: Leiterplatine
- 28: Toleranzausgleichselement
- 30: napfförmiges Teil des Kühlkörpers
- 32: Bodenabschnitt des napfförmigen Teils
- 34: Rand des napfförmigen Teils
- 36: Kühlfinger des Kühlkörpers
- 38: Kupferschicht
- 40: Lot

## Patentansprüche

1. Elektronische Einrichtung, insbesondere elektronischer Regler für eine elektromechanische Anordnung wie z.B. ein Fahrzeuggebläse, mit
- einem zu kühlenden elektronischen Bauteil (14), insbesondere einem Leistungsbauteil in Form eines Transistors, wobei das Bauteil (14) ein Gehäuse (16) mit einer Außenseite, an der mindestens ein Anschlusskontaktelement (18) und mindestens ein zu kühlendes Wärmeabführelement (20) zum Abführen von Wärme von dem Bauteil (14) angeordnet sind, und
- einem mit dem Wärmeabführelement (20) thermisch verbundenen Kühlkörper (12),
- wobei die thermische Verbindung zwischen dem Wärmeabführelement (20) des elektronischen Bauteils (14) und dem Kühlkörper (12) eine mit diesem thermisch gekoppelte Kupferschicht (38) aufweist und
- wobei das Wärmeabführelement (20) mittels eines thermisch leitenden Materials (40) stoffschlüssig mit der Kupferschicht (38) verbunden ist,
**dadurch gekennzeichnet,**
- **dass** der Kühlkörper (12) Aluminium oder eine Aluminiumlegierung aufweist und
- **dass** die Kupferschicht (38) durch thermisches Spritzen auf den Kühlkörper (12) aufgebracht und mit dem Kühlkörper (12) stoffschlüssig verbunden ist.

2. Elektronische Einrichtung nach Anspruch 1, **dadurch gekennzeichnet, dass** die Kupferschicht (38) durch Lichtbogenspritzen, Detonationsspritzen, Flammspritzen, insbesondere Hochgeschwindigkeits-Flammspritzen, Plasmaspritzen oder Kaltgasspritzen auf den Kühlkörper (12) aufgebracht ist.

3. Elektronische Einrichtung nach Anspruch 1 oder 2, **dadurch gekennzeichnet, dass** die thermische Kopplung ferner eine zwischen der Kupferschicht (38) und dem Kühlkörper (12) angeordnete thermisch leitende und elektrisch isolierende Isolationsschicht aufweist.

4. Elektronische Einrichtung nach Anspruch 3, **dadurch gekennzeichnet, dass** die Kupferschicht (38) durch thermisches Spritzen auf die Isolationsschicht aufgebracht ist.

5. Elektronische Einrichtung nach Anspruch 4, **dadurch gekennzeichnet, dass** die Kupferschicht (38) durch Lichtbogenspritzen, Detonationsspritzen, Flammspritzen, insbesondere Hochgeschwindigkeits-Flammspritzen, Plasmaspritzen oder Kaltgasspritzen auf die Isolationsschicht aufgebracht ist.

6. Elektronische Einrichtung nach einem der Ansprüche 3 bis 5, **dadurch gekennzeichnet, dass** die Isolationsschicht keramisches Material aufweist.

7. Elektronische Einrichtung nach Anspruch 6, **dadurch gekennzeichnet, dass** das keramische Material durch thermisches Spritzen auf den Kühlkörper (12) aufgebracht ist.

8. Elektronische Einrichtung nach einem der Ansprüche 3 bis 7, **dadurch gekennzeichnet, dass** die Isolationsschicht mittels eines thermisch leitenden Klebers mit dem Kühlkörper (12) verbunden ist.

9. Elektronische Einrichtung nach einem der Ansprüche 1 bis 8, **dadurch gekennzeichnet, dass** das thermische leitende Material (40) Lot ist.

10. Elektronische Einrichtung nach einem der Ansprüche 1 bis 8, **dadurch gekennzeichnet, dass** das thermische leitende Material ein Kleber ist.

11. Elektronische Einrichtung nach einem der Ansprüche 1 bis 10, **dadurch gekennzeichnet, dass** auf der dem Wärmeabführelement (20) gegenüberliegenden Seite des Gehäuses (16) des elektronischen Bauteils (14) eine Leiterplatine (26) angeordnet ist und dass das mindestens eine Anschlusskontaktelement (18) mit einem Anschlussfeld der Leiterplatine (26) mechanisch und elektrisch verbunden ist.

12. Elektronische Einrichtung nach Anspruch 11, **dadurch gekennzeichnet, dass** zwischen der Leiterplatine (26) und dem Gehäuse (16) des elektronischen Bauteils (14) ein elastisches Toleranzausgleichselement (28) angeordnet ist.

13. Elektronische Einrichtung nach einem der Ansprüche 1 bis 12, **dadurch gekennzeichnet, dass** das Wärmeabführelement (20) auch der elektrischen Kontaktierung des elektronischen Bauteils (14) dient.

## Claims

1. Electronic means, in particular an electronic control for an electro-mechanic assembly, such as a vehicle blower, for example, comprising:
- an electronic component (14) to be cooled, in particular a power component in the form of a transistor, the component (14) comprising a housing (16) with an outer surface on which are arranged at least one terminal element (18) and at least one heat dissipation element (20) which is to be cooled and dissipates heat from the component (14), and
- a cooling body (12) thermally connected with the heat dissipation element (20),
- the thermal connection between the heat dissipation element (20) of the electronic component (14) and the cooling body (12) comprises a copper layer (38) thermally coupled therewith, and
- the heat dissipation element (20) being substance-to-substance bonded with the copper layer (38) via a thermally conductive material (40),
**characterized in that**
- the cooling body (12) comprises aluminum or aluminum alloy, and
- the copper layer (38) is applied onto the cooling body (12) by thermal spraying and is substance-to-substance bonded with the cooling body (12).

2. The electronic means of claim 1, **characterized in that** the copper layer (38) is deposited on the cooling body (12) by arc spraying, detonation spraying, flame spraying, in particular high speed flame spraying, plasma spraying or cold gas spraying.

3. The electronic means of claim 1 or 2, **characterized in that** the thermal coupling further comprises a thermally conductive and electrically insulating insulation layer arranged between the copper layer (38) and the cooling body (12).

4. The electronic means of claim 3, **characterized in that** the copper layer (38) is deposited on the insulation layer by thermal spraying.

5. The electronic means of claim 4, **characterized in that** the copper layer (38) is deposited on the insulation layer by arc spraying, detonation spraying, flame spraying, in particular high speed flame spraying, plasma spraying or cold gas spraying.

6. The electronic means of one of claims 3 to 5, **characterized in that** the insulation layer comprises ceramic material.

7. The electronic means of claim 6, **characterized in that** the ceramic material is deposited on the cooling body (12) by thermal spraying.

8. The electronic means of one of claims 3 to 7, **characterized in that** the insulation layer is bonded to the cooling body (12) by means of a thermally conductive adhesive.

9. The electronic means of one of claims 1 to 8, **characterized in that** the thermally conductive material (40) is solder.

10. The electronic means of one of claims 1 to 8, **characterized in that** the thermally conductive material is an adhesive.

11. The electronic means of one of claims 1 to 10, **characterized in that** a circuit board (26) is provided on the side of the housing (16) of the electronic component (14) opposite the heat dissipation element (20) and that the at least one terminal element (18) is mechanically and electrically connected with a terminal pad of the circuit board (26).

12. The electronic means of claim 11, **characterized in that** an elastic tolerance compensation element (28) is provided between the circuit board (26) and the housing (16) of the electronic component (14).

13. The electronic means of one of claims 1 to 12, **characterized in that** the heat dissipation element (20) also serves the electric contacting of the electronic component (14).

## Revendications

1. Dispositif électronique, à savoir un commande électronique pour un ensemble électromécanique comme un ventilateur de véhicule, par exemple,
- une composante électronique (14) à refroidir, à savoir une composante de puissance sous forme d'un transistor, la composante (14) ayant un boîtier (16) avec une face extérieure sur laquelle sont prévus au mois un élément de borne (18) et au moins un élément de dissipation de chaleur (20) à refroidir pour la dissipation de la chaleur de la composante (14), et
- un radiateur (12) thermiquement lié à l'élément de dissipation de chaleur (20),
- le lien thermique entre l'élément de dissipation de chaleur (20) de la composante électronique (14) et le radiateur (12) comprend une couche de cuivre (38) liée thermiquement audit radiateur, et
- l'élément de dissipation de chaleur (20) étant lié matériellement à la couche de cuivre (38) à l'aide d'un matériau conducteur thermique (40),
**caractérisé en ce que**
- le radiateur (12) comprend de l'aluminium ou d'un alliage d'aluminium, et
- la couche de cuivre (38) est déposée sur le radiateur (12) par pulvérisation thermique et est liée matériellement au radiateur (12).

2. Dispositif électronique selon la revendication 1, **caractérisé en ce que** la couche de cuivre (38) est déposée sur le radiateur (12) par pulvérisation par l'arc électrique, pulvérisation par détonation, pulvérisation par la flamme, à savoir pulvérisation par la flamme à haute vitesse, pulvérisation au plasma ou pulvérisation par gaz froid.

3. Dispositif électronique selon la revendication 1 ou 2, **caractérisé en ce que** la liaison thermique comprend en outre une couche conductrice thermique et isolatrice électrique agencée entre la couche de cuivre (38) et le radiateur (12).

4. Dispositif électrique selon la revendication 3, **caractérisé en ce que** la couche de cuivre (38) est déposée sur la couche isolatrice par pulvérisation thermique.

5. Dispositif électrique selon la revendication 4, **caractérisé en ce que** la couche de cuivre (38) est déposée sur la couche isolatrice par pulvérisation par l'arc électrique, pulvérisation par détonation, pulvérisation par la flamme, à savoir pulvérisation par la flamme à haute vitesse, pulvérisation au plasma ou pulvérisation par gaz froid.

6. Dispositif électrique selon une quelconque des revendications 3 à 5, **caractérisé en ce que** la couche isolatrice comprend de matériau céramique.

7. Dispositif électrique selon la revendication 6, **caractérisé en ce que** le matériau céramique est déposée sur le radiateur (12) par pulvérisation thermique.

8. Dispositif électrique selon une quelconque des revendications 3 à 7, **caractérisé en ce que** la couche isolatrice est liée au radiateur (12) par un adhésif conducteur thermique.

9. Dispositif électrique selon une quelconque des revendications 1 à 8, **caractérisé en ce que** le matériau conducteur thermique (40) est un métal d'apport de brasage.

10. Dispositif électrique selon une quelconque des revendications 1 à 8, **caractérisé en ce que** le matériau conducteur thermique est un adhésif.

11. Dispositif électrique selon une quelconque des revendications 1 à 10, **caractérisé en ce qu'**une carte imprimée (26) est agencée à la face du boîtier (16) opposée à l'élément de dissipation de chaleur et que l'au moins un élément de borne (18) est raccordé mécaniquement et électriquement à un dépôt conducteur de la carte imprimée (26).

12. Dispositif électrique selon la revendication 11, **caractérisé en ce qu'**un élément compensateur de tolérances (28) élastique est agencé entre la carte imprimée (26) et le boîtier (16) de la composante électronique (14).

13. Dispositif électrique selon une quelconque des revendications 1 à 12,
**caractérisé en ce que** l'élément de dissipation de chaleur (20) aussi sert à brancher la composante électronique (14) électriquement.
